Europäisches Patentamt

European Patent Office

Office européen des brevets

(19)

(11) Publication number: **0 160 518 B1**

(12) **EUROPEAN PATENT SPECIFICATION**

(45) Date of publication of patent specification: **12.06.91**　(51) Int. Cl.⁵: **G06K 15/12**, H01J 31/15, H01J 29/89

(21) Application number: 85302905.6

(22) Date of filing: **25.04.85**

(54) Optical image bar.

(30) Priority: **01.05.84 US 605731**
**01.05.84 US 605728**

(43) Date of publication of application:
**06.11.85 Bulletin 85/45**

(45) Publication of the grant of the patent:
**12.06.91 Bulletin 91/24**

(84) Designated Contracting States:
**DE FR GB**

(56) References cited:
**FR-A- 2 272 453**　　**FR-A- 2 358 681**
**US-A- 3 406 288**　　**US-A- 3 780 326**
**US-A- 4 134 668**　　**US-A- 4 218 636**
**US-A- 4 291 341**

(73) Proprietor: **XEROX CORPORATION**
**Xerox Square - 020**
**Rochester New York 14644(US)**

(72) Inventor: **Genovese, Frank Cono**
**17 Selborne Chase**
**Fairport New York 14450(US)**
Inventor: **Lannom, James Wayne**
**500 Basket Road**
**Webster New York 14580(US)**

(74) Representative: **Weatherald, Keith Baynes et al**
**Rank Xerox Patent Department Albion House, 55 New Oxford Street**
**London WC1A 1BS(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to a printing device for exposing a photosensitive member and, more particularly, to an active light bar which creates precisely-controlled marks on a photosensitive member from a digital electronic bit stream that represents a document of which a copy is desired.

Typical medium-to-high quality electronic printing systems have resolutions of 12 or more pixels (picture elements) per mm. Usually, the resolution or pixel density is the same in both directions on the page, but this is not necessarily the case for all systems. Each bit of the electronic image is mapped to its approximate pixel location on a grid that covers the page and defines the resolution of the system. The size of the mark that is made at each location depends on the particular marking process being used and may be smaller, but is usually larger, than the addressability of the system. For example, a round laser dot with a diameter of 0.08 mm may be used for exposure in a system with addressable elements arranged in a square array of 0.06 mm centers. With a raster scan, the information transfer is continuous, a bit at a time within each scan line being supplied, one line after another in linear succession. However, in principle, the order of mapping pixels is perfectly arbitrary. The choice usually depends wholly on practical considerations.

For an active light bar of a given resolution, the printing speed fixes the maximum time available to make the exposure of the photosensitive member, a 250 mm width processed at 250 mm per second requires a minimum of 3871 ergs/sec or 0.387 milliwatts delivered to its surface. The process time per pixel mapped one-at-a-time at 12 x 12 per mm is only 111 nanoseconds.

When the system permits many points to be mapped simultaneously, these stringent time restraints are relaxed. Data processed in parallel can be handled by slower, less expensive logic and circuits in general are much easier to design for low speed applications. The average power output of an individual element is reduced significantly when multiple elements can be used in parallel. The greater the number of sources that contribute to the net output, the greater the total available light and the longer the potential life of an individual element.

Various approaches to xerographic reproduction with cathode ray tubes (CRT) are known, as well as vacuum fluorescent approaches to displaying character symbols by the use of anodes.

The following disclosures appear to be relevant:

US-A-3 641 557 discloses a circuit arrangement for modulating the pattern of voltages appearing on a set of electrodes in an electric discharge tube that displays character symbols on the face thereof.

US-A-3 780 326 discloses an evacuated envelope having a transparent display face which contains a plurality of selectively energizable, phosphor-coated anode display elements for presenting a symbol display, with an auxiliary electrode disposed either behind or coplanar with said display elements and electrically insulated therefrom. A cathode comprising one or more filaments is situated in front of the display elements.

US-A-4 004 186 discloses a vacuum fluorescent display having a grid plate substantially coplanar with an anode and which is controllable with conventional metal oxide semiconductor devices. Each digit of the display includes a segmented anode structure substantially surrounded by a control electrode or grid plate.

US-A-4 041 348 discloses a multi-figure fluorescent display tube which includes in a casing a plurality of anode display portions formed of segment electrodes each having a fluorescent material layer thereon, cathodes and control electrodes being disposed opposite to the anode display portions.

US-A-4 047 072 discloses a multi-column fluorescent display tube having a casing composed of a base plate and a cover plate, multi-column pattern display sections each composed of a plurality of segment anodes with fluorescent material layers thereon provided on the upper surface of the base plate, cathodes provided opposite to the pattern display sections, and electrification-preventive layers provided around and in the vicinity of the segment anodes on the base plate and electrically connected to prevent electrification and to intercept an external electric field.

US-A-4 047 074 discloses a multi-column fluorescent display tube having a filament cathode provided opposite to a plurality of fluorescent display sections, which comprises at least a filament damper made of an insulating material low in thermal conductivity and filament damper supporters.

US-A-4 134 668 discloses a combined copying and printing apparatus that includes a conventional copying apparatus and a non-impact printer that uses a black on white cathode ray tube optical display to form a latent electrostatic image on the photoreceptor of the copier.

US-A-4 190 787 discloses a phosphorous luminescent display tube of the triode type having, in a vacuum casing, a filamentary cathode for emitting thermions, a controlled electrode for accelerating and controlling the thermions emitted from the cathode, a plurality of pattern display sections each composed of a plurality of segment anodes each coated with a phosphor layer for emitting light when the thermions impinge thereon, and auxiliary anode conductors provided in the vicinity of and substantially on the same level with the segment anodes.

US-A-4 270 068 discloses a fluorescent display device having a filamentary cathode for emitting electrons, pattern display sections each coated with fluorescent material, a plurality of control electrodes electrically independent of one another provided opposite to the pattern display sections respectively, the anodes and control electrodes being selectively given drive signals thereby to make the electrons emitted from the filamentary cathode impinge on the anodes so as to display characters, and a plurality of auxiliary electrodes provided at or above and in the vicinity of gaps between the control electrodes.

US-A-4 291 341 discloses a copying apparatus that employs an electro-optical converter means in the form of an optical fiber tube.

US-A-4 293 793 discloses a fluorescent display tube in which the electron-stream transmission of a grid electrode is controlled by shielding regions of solid or fine mesh form provided in each of the grid meshes in opposing relationship to the exposed insulating portions of an anode substrate lying within the corresponding set of anode segments.

US-A-4 298 823 discloses a fluorescent display device having a grid which is divided into several pieces electrically separated and disposed in close proximity and in an opposed relationship at the edges thereof. The grids are held in position within the display device by an elongated insulator.

US-A-4 096 486 discloses an optical image bar which is adapted to use in conjunction with a light-sensitive record medium in order to create images from electronically generated data. It comprises an array of areas emitting light in a pattern dictated by the data signals. A lens is aligned with each light emitting area to receive light and direct it to specific areas in the plane of the light sensitive record medium.

In addition, Ricoh's Japanese Laid-Open Patent Application No. 55-168961/1980 discloses a light tube that is used to transmit light to a photosensitive member. Further, in the publication Mini-Micro World/Mini-Micro Systems of May 1983, on pages 56, 58 and 64, a method of imaging with staggered arrays of recording heads is disclosed.

It has been shown that CRT's can be used in several configurations to generate xerographic images. They can be addressed rapidly and emit sufficient light to expose existing photoreceptors even at relatively high speed and still be gated within the available time. However, they are bulky and expensive and require complex support circuitry. The dynamics of electron-beam deflection makes it difficult to produce light patterns that are bright, very high in resolution, exactly rectilinear, and very stable in location, all at the same time.

Some of these problems can be alleviated by using a conventional lens as a light transmitting means from either the front or rear of the device. However, a disadvantage in employing this conventional lens to project light is that it is difficult to design and expensive to manufacture a lens having both wide field and high collection efficiency at moderate resolution as is desired.

The optical image bar of the present invention addresses this desire for a device that accomplishes both wide field and high collection efficiency at moderate resolution and includes a uniquely constructed vacuum fluorescent device that is configured in a two-dimensional array and comprises controllable light emitting elements that expose a photosensitive member in imagewise configuration in accordance with electronic stimulation. The optical image bar includes a fly's-eye lens light-coupling means for transmitting light from the image bar to the photosensitive member.

A preferred feature of the present invention is to provide a small, compact and economical electronically addressable optical active light bar for exposing a photosensitive member, and includes an anode substrate on which a fluorescent material is placed and masked in a skewed segment configuration. Also, it should be understood that individual anode segments could be used instead of a uniform anode that is masked for segments if desired. Control grids are placed over the anode to gate emissions from cathode filaments spaced above the grids. A cover plate having a transparent conductive coating on its inside surface and a fly's-eye lens array bonded to its outer surface mates with the control grid structure and anode substrate to form a hermetically sealed unit. Electrons emitted from the cathode filaments are gated by the grid structure and excite the masked phosphor-coated anode areas which in turn expose the photosensitive member through the lens array.

Further features and advantages of the invention pertain to the particular apparatus whereby the above-noted aspects of the invention are obtained. Accordingly, the invention will be better understood by reference to the following description, and to the drawings forming a part thereof, which are approximately to scale, wherein:

Figure 1 is an isometric view of the optical image bar of the present invention exposing a photosensitive member.

Figure 2 is a partially-exploded isometric view of a small area of the image bar shown in Figure 1.

Figure 3 is a partial elevational schematic view of the image bar of the present invention shown projecting an image through the front of the bar.

Figure 4 is a partial elevational schematic of an alternative embodiment of the present optical image bar that projects an image through the rear of the bar.

Figure 5 is an elevational view of a schematic of the optical image bar of the present invention shown in use with a curved surfaced photosensitive member.

Figure 6 shows alternative lens arrays for the device of the present invention.

Figure 7 is an isometric view of the zone/phase plate array of Figure 6 including light baffles.

Figure 8 is an elevational view of a partial schematic showing an alternative embodiment of the present invention that utilizes light emitted from either the front or back of an image bar.

The device of the present invention will now be described in detail with reference to the Figures where like reference numerals will be employed throughout to designate identical elements. Although the device for receiving electrical signals and generating an optical output is particularly well adapted for use in a reprographic machine, it is equally well suited for use in a wide variety of applications and is not necessarily limited to the particular embodiment disclosed.

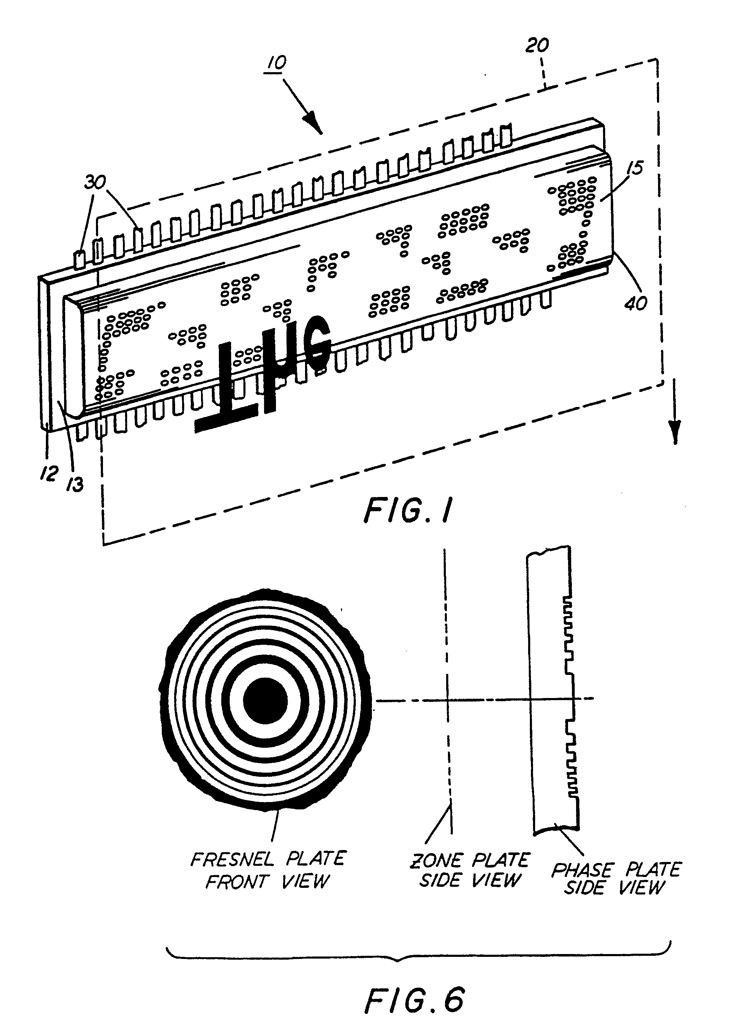

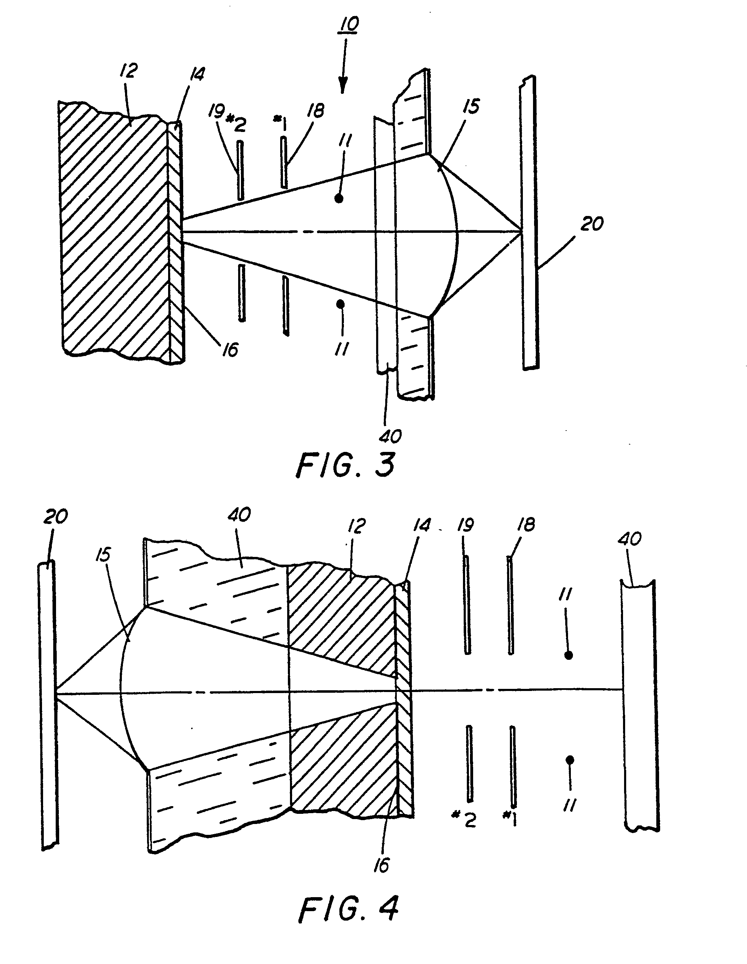

Referring now to Figure 1, a vacuum fluorescent device or optical light printing bar 10 is shown with many controllable light-emitting masked elements 16 that are positioned under an array of fly's-eye lenses 15. The light bar is used as an image generating device in conjunction with a light-sensitive record medium 20, e.g., photographic film, photoresist, photoreceptors, etc., for the purpose of creating electronically-generated images on that medium. Within the printing bar, as shown in Figure 3, electrons emitted from hot filaments 11 are gated by grid structures 18 and 19 to excite phosphor 14 on phosphor-coated anode substrate 12. Above anode substrate 12 are gated grid structures 18 and 19. Grid terminals 30 are connected to a multiplex control circuitry for gating purposes. Cathode filaments 11 are positioned to generate electron emission toward the grid structures when energized. A cover plate 40 having a transparent conductive film on its inside surface is attached to anode substrate 12 in such a manner as to form an air-free hermetically-sealed unit 10. A high vacuum is maintained through the use of a conventional getter. The device of the present invention presents 4096 elements in a 16 x 256 matrix addressable array, 16 rows and 256 columns (or any equivalent combination and not necessarily rectangular in shape) to cover a photoreceptor or other photosensitive member width of 260 mm at a system resolution of 16 pixels per mm. Only 272 control lines spaced on 0.25 mm centers along both lengthwise sides of the device are required for creating a fluorescent output, and these control lines are assembled in a tube envelope of approximately 300 mm in length.

The optical light bar 10 is matrix-controlled according to the truth table shown below and functions as a logical AND gate provided the control voltages $G_m$ and $A_n$ swing widely enough. In the table G refers to grids 18 and 19, and A is anode 12.

## TRUTH TABLE

| $G_m$ | $A_n$ | OUTPUT$_{m,n}$* |
|---|---|---|
| low | low | off |
| low | high | off |
| high | low | off |
| high | high | on |

*for example,  Grids:  -2 volts = low; +2 volts = high

Anodes:  0 volts = low;  +50 volts = high

This strictly logical behavior provides a distinct advantage over other matrix-controlled devices, such as liquid crystal displays. In those devices, control is based on the sharp voltage threshold of a material property of the light-modulating or -emitting material that is positioned between the electrical control elements. The state of the material depends only on the voltage difference between the control elements. In the present invention 256 columns are controlled by 256 grids G designed to be driven by relatively low TTL logic (up to 30 volts using ordinary open collector chips, or up to 150 volts using special display-driver chips), operated at low current levels (grid currents are in the microampere range) with a minimum number of connections. The binary number 256 was chosen because it represents a significant reduction in the number of necessary external interconnections leading to a compact package, and is a convenient number

4

for the design of the computer-controlled drive circuitry. In this grid-anode multiplexing arrangement, with the image data presented on the grid columns, the 16 rows of anodes are energized sequentially permitting them to emit light under control of the grids. The imaging data, presented at the 256 grids, control the pattern of electron beam current passing to each anode row in succession. It is the phosphor on the anode which generates the useful light output pattern from the device. Each anode row is energized in succession so that the same 256 grids serve each row one at a time. Since the system has only 16 rows, the associated circuits driving each row can be fabricated from discrete components if necessary permitting, but not necessarily requiring, the use of tailored switching circuit designs that can deliver higher voltages and currents than currently available from integrated chips.

Known electronics, including conventional buffers and drivers, drive optical image bar 10. In operation, a conventional data source such as a computer sends appropriate video data to a multiplex/controller constructed of conventional integrated circuit chips. The controller then sorts the video data input signals and, with the proper timing, sends the correct signals to a column buffer/driver and to a row decoder also constructed of conventional integrated circuit chips. The row decoder keeps track of which row is active, and signals the row buffer/drivers accordingly to deliver the proper row selection potential swing.

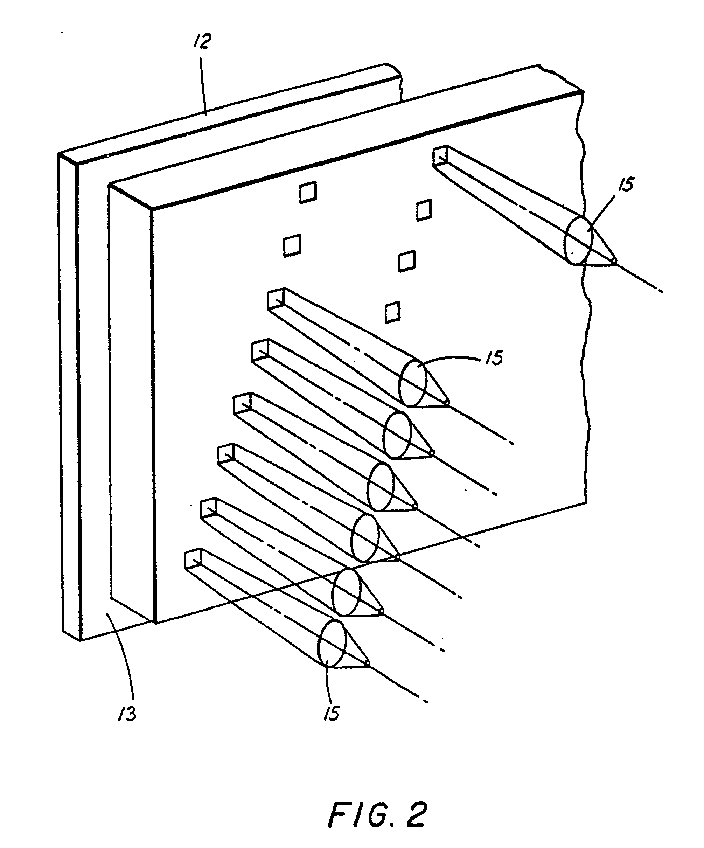

A vacuum fluorescent device containing a large number of electronically-controllable light sources in some fixed pattern is not by itself sufficient to make a useful print bar apparatus. In conventional vacuum fluorescent tubes, practical considerations limit the closest physical spacing of individually controlled light emitting segments to approximately 0.38 - 0.50 mm. With this limitation, placing all 4096 segments of print bar 100 in a single space at about 16 to the mm is precluded. However, if the segments are arranged in a rectangular array located 1 mm apart in both the X and Y directions, forming an active area of 15 mm in width and 260 mm in length, and the array is inclined by 1 mm with respect to the direction of photoreceptor motion, the minimum spacing requirements for the anodes as well as the grids and terminals are easily accommodated. Guiding the light ouput from each seqment to its proper location on photosensitive surface as shown in Figure 2 is by a fly's-eye lens array that is molded directly to the cover 40 of the image bar. The fly's-eye lens array has several advantages over conventional lenses, including a significant reduction in overall size of the system. Either front or rear projection geometrics can be used. Figure 1 shows an array of lenses used in the front projection configuration in close proximity to a photosensitive surface.

Figure 2 is a close-up exploded view of a portion of the device shown in Figure 1. Each lens has an axis such that the collection efficiency is maximized with little degradation of image quality. It should be understood that aspherical lens surfaces could be used if desired to improve optical performance. The fly's-eye array is fabricated so that the lenses are centered over the unmasked segments or areas of the anode one-on-one, with light baffles strategically located to prevent crosstalk from any segment through adjacent lenses. The lenses can be molded from plastics and bonded directly to the optical bar in either front or rear projection configurations as shown in Figures 3 and 4. Baffles can be formed by lithographic methods on either or both surfaces of the lens array or on the optical bar itself. Alternatively, self-supporting foils or thin flat glass sheets with arrays of etched apertures can be positioned anywhere along the optical axis both inside and outside the vacuum envelope.

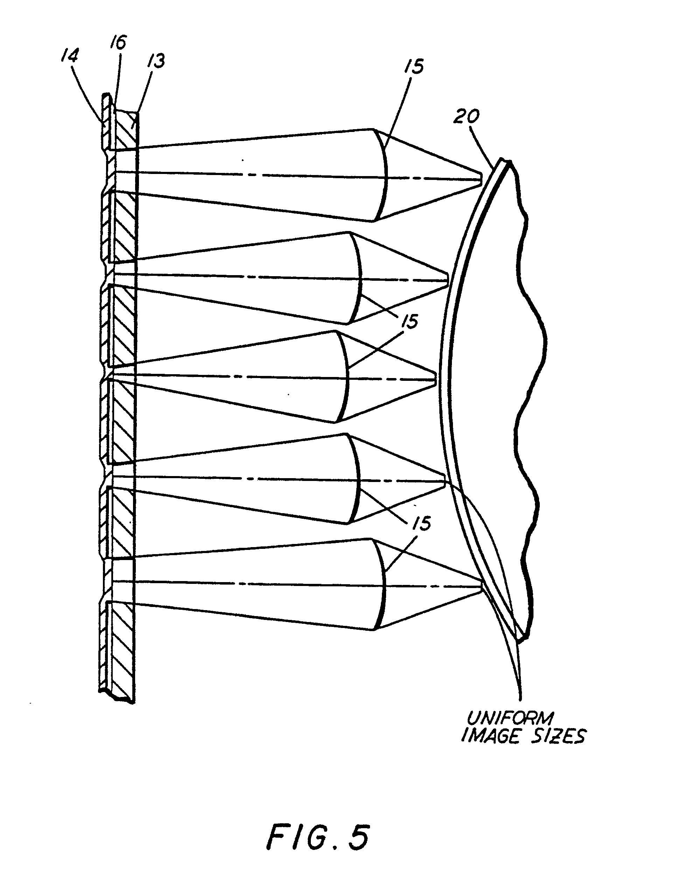

Since the system contains 4096 identical optical systems in parallel, each can be tailored for a specific magnification and image plane. For example, by using a lens designed for 4:1 reduction as implied in Figures 2, 3 and 4, the object apertures in the image bar can be four (4) times the pixel size regardless of the pixel spacing or pitch of the system. By being bigger than life size, the defining apertures in the bar structure are easier to fabricate to a higher degree of uniformity, and statistical variation in brightness from segment to segment because of phosphor graininess is reduced. It also increases the working distance on the device side by a factor of 4. By designing each of the sixteen (16) rows to have a slightly different image distance, the "best image" surface can be made to conform to a drum photoreceptor's cylindrical surface or a belt photoreceptor passing over a guide roller. By compensating the defining aperture size slightly and positioning each row of lenses at the proper object-lens distance, the same lens shape can be used for all rows as shown in Figure 5. Otherwise, a slightly different lens curvature is needed for each row.

Arrays of fly's-eye lenses have been fabricated that exhibit near diffraction-limited behavior over areas of several $\mu$m diameter at f:2 using spherical lenses. This is better than twenty (20) times the resolution necessary for the intended application. Light collection efficiency can be improved by extension to a lower f: number, limited eventually by the index of refraction of the lens material and the maximum space available between lenses.

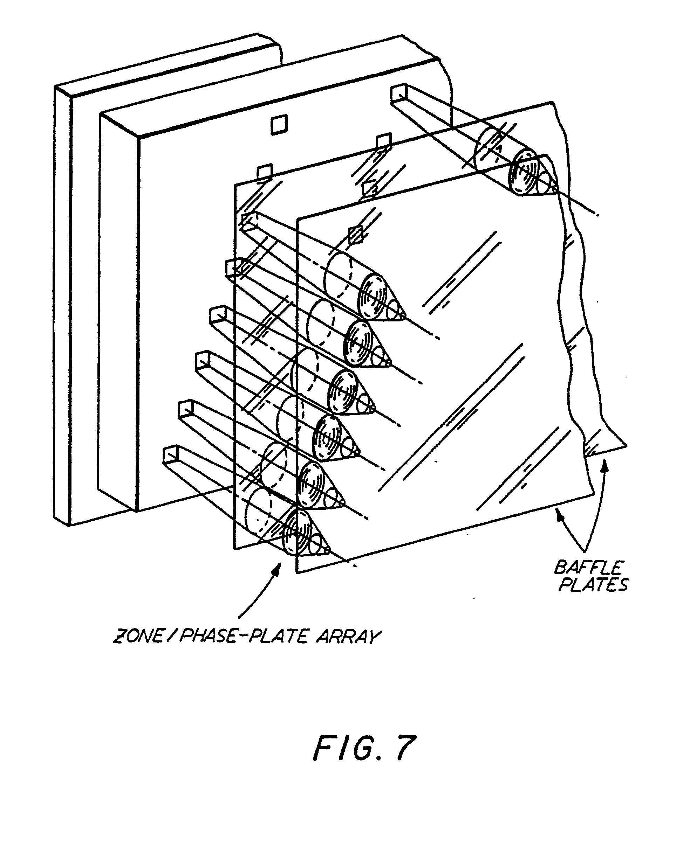

Alternatively, a Fresnel lens array, or the Fresnel zone and phase plate array shown in Figures 6 and 7, could be used as the light coupling means for optical bar 10. The Fresnel lens is a segmented lens, and as such would be difficult to make on a mass production scale. However, a Fresnel zone or phase plate, diagrammed schematically in Figure 6, can be made photolithographically from an optical mask generated by step-and-repeat methods. This has the advantage that the positions of photographically identical "lenses" can be very precisely controlled. The master artwork can be generated at many times life-size by computer-aided design methods and reduced photographically to working size. The zone and phase plates can be optimized with the same properties on-axis as the aspheric lens by adjusting the positions of the zones. The difference between a zone and phase plate is that the alternate zones in a phase plate are etched to yeild 1/2 wave retardation seen in the side view in Figure 6, whereas in a zone plate they are blocked by opaque material. Although the focusing properties of Fresnel lenses are wavelength-dependent, the phosphors to be used in optical bar 10 can be chosen that match the photosensitive medium and emit a relatively narrow band of wavelengths so that they can be considered monochromatic in this application. Photolithographic methods, which are ideal for mass production, have been used to make arrays of zone and phase plates with focal lengths less than 2.5 mm on glass at f:4. The finished Fresnel devices are rugged and the images they form are essentially diffraction-limited. In one alternative application, the devices can be formed directly on the optical bar substrate before assembly, which would present good registration with the underlying anode segments. To prevent unwanted images created from different diffraction orders, baffles as shown in Figure 7 are placed between the plane of the zone/phase plate and the image. The Fresnel lens approach is most useful for a relatively-sensitive record medium, such as moderately high speed photographic film.

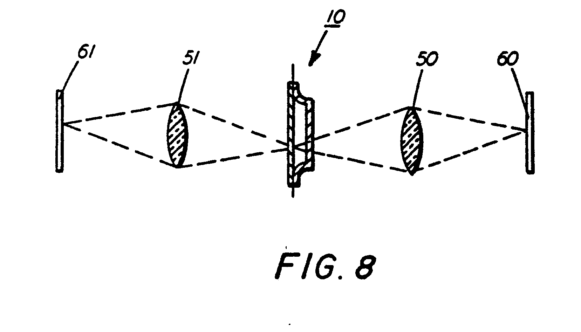

Two photoreceptors can be exposed simultaneously by guiding the light output from each segment to its proper location on photoreceptor 60 or 61 as shown in Figure 8 by the use of a conventional 1:1 lens or optical coupling means 50 or 51. With this type of optical coupling means individual anodes are masked by an opaque layer to define the active light output region precisely, and skewed slightly so that they are displaced a proper amount when imaged on the photoreceptor. This arrangement lends itself to simplified control by a relatively coarse overlying grid structure, because the active elements are spaced far apart. For the same image size and resolution at the photoreceptor, magnifications through the optical coupling means 50 or 51 that are greater than unity require higher pixel density in the display, while magnifications less than unity require an oversize display. As shown in Figure 8, light emitted from either the front or back of print bar 10 can be used. The only change required to utilize light emitted from the back of the structure of print bar 10 would be to make the anode support substrate and anodes transparent, and relocate the mask.

In conclusion, a fly's-eye matrix light-coupling method and apparatus is shown for an optical print bar, and includes a lens strip having a molded, phase-array, or zone plate lenslet array bonded directly to the optical print bar, with baffles and staggering to allow a skewed rectangular array of phosphor sources to address a photosensitive surface and generate a high-resolution image with a large number of pixels.

## Claims

1. An optical image bar (10) for use in conjunction with a light-sensitive record medium (20) in order to create images from electronically-generated data, comprising:
   a substrate (12) of electrical insulation material supporting a layer (14) on one face of anodic material adapted to fluoresce over a narrow band of wavelengths;
   a plurality of thermionic cathodes (11) spaced from the anodic layer;
   at least one control grid (18, 19) positioned between the cathodes and the anodic layer, the or each control grid being adapted to be connected with a source of data signals to cause electrons emitted by the cathodes to fall on localised areas of the fluorescent material to cause them to emit light in a pattern dictated by the data signals, and
   an array of Fresnel lenses each aligned with one of the localised areas of fluorescent material to receive the emitted light and direct it to specific areas in the plane of the light-sensitive record medium, with each Fresnel lens being in the form of a combined Fresnel zone and phase plate.

2. The optical image bar as claimed in Claim 1, wherein the localised areas are defined by a mask positioned between the control grid(s) and the anodic layer.

3. The optical image bar as claimed in claim 1 or 2, wherein the light bar has front and back surfaces, and light is intended to be emitted through at least one of the surfaces.

4. The optical image bar as claimed in any preceding claim, in which the lenses of the array are of different focal lengths adapted to produce a focussed image on a non-planar photosensitive surface.

5. A method of making the optical image bar as claimed in any preceding claim, comprising the steps of:
(a) providing a substrate of insulation material;
(b) covering the substrate with a uniform anode;
(c) covering the anode with a layer of a fluorescent substance;
(d) providing a plurality of thermionic cathodes spaced from the anode;
(e) positioning a control grid between the cathodes and the anode, the control grid being adapted to allow electrons emitted from the cathodes to pass to selected areas of the anode in response to signals from a source of digitized image data thereby to excite the fluorescent substance on the anode in the selected areas to cause the fluorescent substances to emit light, and
(f) providing a Fresnel lens array, in the form of an array of Fresnel zone and phase plates, to receive and transmit the emitted light to the photosensitive member.

6. The method of Claim 5, including the step of masking the anode so as to define discrete areas of the fluorescent substance which are to be excited by the incidence of electrons on them.

7. A method as claimed in any of claim 5 or 6, comprising the step of forming the localised areas into a skewed matrix with respect to the longitudinal axis of the substrate.

**Revendications**

1. Barreau optique de formation d'image (10) pour utilisation en association avec un support d'enregistrement photosensible (20) afin de créer des images à partir de données élaborées électroniquement, comprenant:
un substrat (12) de matériau d'isolation électrique supportant une couche (14) sur une face d'un matériau anodique adapté à présenter une fluorescence dans une bande de longueurs d'ondes étroite;
une pluralité de cathodes thermioniques (11) espacées de la couche anodique;
au moins une grille de commande (18, 19) disposée entre les cathodes et la couche anodique, la grille de commande, ou chacune des grilles de commande, étant adaptée à être connectée à une source de signaux de données pour provoquer l'impact d'électrons émis par les cathodes sur des zones localisées du matériau fluorescent pour qu'ils émettent de la lumière suivant un motif fixé par les signaux de données, et
un réseau de lentilles de Fresnel qui sont toutes alignées avec l'une des zones localisées en matériau fluorescent, afin de recevoir la lumière émise et de la diriger vers des zones spécifiques dans le plan du support d'enregistrement photosensible, chaque lentille de Fresnel ayant la forme d'une lame zonée de Fresnel et d'une lame de phase.

2. Barreau optique de formation d'image selon la revendication 1, dans lequel les zones localisées sont définies par un masque disposé entre la ou les grille(s) de commande et la couche anodique.

3. Barreau optique de formation d'image selon la revendication 1 ou 2 dans lequel le barreau lumineux présente des surfaces avant et arrière, de la lumière devant être émise par au moins l'une de ces surfaces.

4. Barreau optique de formation d'image selon l'une quelconque des revendications précédentes, dans lequel les lentilles du réseau ont des distances focales différentes adaptées à produire une image focalisée sur une surface photosensible non plane.

5. Méthode de réalisation d'un barreau optique de formation d'image selon l'une quelconque des revendications précédentes, comprenant les étapes consistant à:
(a) réaliser un substrat de matériau isolant;
(b) recouvrir le substrat d'une anode uniforme;
(c) recouvrir l'anode d'une couche de substance fluorescente;
(d) réaliser une pluralité de cathodes thermioniques espacées de l'anode;
(e) disposer une grille de commande entre les cathodes et l'anode, la grille de commande étant adaptée à laisser passer des électrons émis par les cathodes vers des zones sélectionnées de l'anode, en réponse à des signaux provenant d'une source de données d'images numérisées, afin d'exciter la substance fluorescente sur l'anode dans les zones sélectionnées, et de provoquer l'émission de lumière par les substances fluorescentes, et

(f) réaliser un réseau de lentilles de Fresnel sous forme de lames zonées de Fresnel et de lames de phase, afin de recevoir et de transmettre la lumière émise par l'élément photosensible.

6. Méthode selon la revendication 5, comprenant l'étape consistant à masquer l'anode de façon à définir des zones discontinues de substance fluorescente discontinue, devant être excitées par des électrons incidents sur celles-ci.

7. Méthode selon l'une quelconque des revendications 5 ou 6, comprenant l'étape consistant à réaliser les zones localisées sous la forme d'une matrice décalée par rapport à l'axe longitudinal du substrat.

## Ansprüche

1. Ein optischer Bildbalken (10) zur Verwendung in Verbindung mit einem lichtempfindlichen Aufzeichnungsmedium (20), um Bilder aus elektronisch erzeugten Daten zu erzeugen, mit:

einem elektrisch isolierendes Material aufweisenden Substrat (12), das auf einer Vorderseite aus Anodenmaterial eine Schicht (14), welche dazu vorgesehen ist, über ein schmales Band von Wellenlängen zu fluoreszieren, trägt;

einer Vielzahl von thermionischen Kathoden (11), die von der Anodenschicht beabstandet sind;

wenigstens einem Steuergitter (18, 19), das zwischen den Kathoden und der Anodenschicht angeordnet ist, wobei das oder jedes Steuergitter dazu vorgesehen ist, mit einer Quelle von Datensignalen verbunden zu sein, um zu bewirken, daß von den Kathoden emittierte Elektronen auf lokalisierte Bereiche des fluoreszierenden Materiales fallen, um diese zu veranlassen, Licht in einem durch die Datensignale erzwungenen Muster zu emittieren, und

einem Feld von Fresnellinsen, von denen jede mit einem der lokalisierten Bereiche des fluoreszierenden Materiales ausgerichtet ist, um das emittierte Licht zu empfangen und es auf spezielle Bereiche in der Ebene des lichtempfindlichen Aufzeichnungsmediums zu lenken, wobei jede Fresnellinse in der Form einer kombinierten Fresnelzonen- und -phasenplatte vorliegt.

2. Der optische Bildbalken nach Anspruch 1, wobei die lokalisierten Bereiche durch eine zwischen dem Steuergitter (den Steuergittern) und der Anodenschicht positionierten Maske definiert sind.

3. Der optische Bildbalken nach Anspruch 1 oder 2, wobei der Lichtbalken Front- und Rückenflächen aufweist und das Licht durch wenigstens eine der Oberflächen zu emittieren beabsichtigt wird.

4. Der optische Bildbalken nach wenigstens einem der vorhergehenden Ansprüche, wobei die Linsen des Feldes unterschiedliche Brennweiten aufweisen, was dazu vorgesehen ist, ein fokussiertes Bild auf einer nicht-planaren photoempfindlichen Oberfläche zu erzeugen.

5. Ein Verfahren zur Herstellung eines optischen Bildbalkens nach wenigstens einem der vorhergehenden Ansprüche, mit den Verfahrensschritten:
    (a) Vorsehen eines Substrates aus isolierendem Material;
    (b) Bedecken des Substates mit einer gleichmäßigen Anode;
    (c) Bedecken der Anode mit einer Schicht aus einer fluoreszierenden Substanz;
    (d) Vorsehen einer Mehrzahl von thermionischen Kathoden, die von der Anode beabstandet sind;
    (e) Anordnen eines Steuergitters zwischen den Kathoden und der Anode, wobei das Steuergitter dazu vorgesehen ist, von den Kathoden emittierten Elektronen zu ermöglichen, sich zu ausgewählten Bereichen der Anode in Reaktion auf Signale aus einer Quelle digitalisierter Bilddaten zu bewegen, um dadurch die fluoreszierende Substanz auf der Anode in den ausgewählten Bereichen anzuregen, um zu bewirken, daß die fluoreszierenden Substanzen Licht emittieren, und
    (f) Vorsehen eines Fresnellinsenfeldes in der Form von eines Feldes von Fresnelzonen- und -phasenplatten, um das emittierte Licht zu empfangen und zu dem photoempfindlichen Element zu übertragen.

6. Das Verfahren nach Anspruch 5, welches den Schritt der Maskierung der Anode enthält, um so diskrete Bereiche der fluoreszierenden Substanz zu bilden, welche durch den Einfall von Elektronen anzuregen sind.

7. Ein Verfahren nach Anspruch 5 oder/und 6, welches den Schritt der Bildung der lokalisierten Bereiche in einer abgeschrägten Matrix in bezug auf die Längsachse des Substrates enhält.

*FIG. 1*

FRESNEL PLATE
FRONT VIEW

ZONE PLATE
SIDE VIEW

PHASE PLATE
SIDE VIEW

*FIG.6*

FIG. 2

FIG. 3

FIG. 4

UNIFORM
IMAGE SIZES

FIG.5

BAFFLE
PLATES

ZONE / PHASE-PLATE ARRAY

FIG. 7

FIG. 8